# EUROPEAN PATENT APPLICATION

(11) **EP 1 432 041 A2**
(43) Date of publication of application: **23.06.2004**
(21) Application number: 03104650.1
(22) Date of filing: 11.12.2003
(51) Int. Cl.: H01L 29/735, H01L 29/08

(54) **LATERAL-CURRENT-FLOW BIPOLAR TRANSISTOR WITH HIGH EMITTER PERIMETER/AREA RATIO**

(30) Priority: 17.12.2002 IT TO20021090
(71) Applicant: STMicroelectronics S.r.l., 20041 Agrate Brianza (Milano) (IT)
(72) Inventor: PATTI, Davide, 95122, CATANIA (IT)
(74) Representative: Jorio, Paolo, Dr. Ing.

(57) **Abstract**

A lateral-current-flow integrated transistor, formed in an epitaxial layer (52) defining a base well (58) with a first conductivity type, which accommodates emitter and collector regions (60-62) of a second conductivity type. The collector region is formed by an internal conductive region (62) and by an external conductive region (60), and the emitter region is formed by an intermediate conductive region (61). The external conductive region (60) has an annular shape and surrounds the intermediate conductive region (61), which also has an annular shape and surrounds the internal conductive region (62).

## Description

The present invention relates to a lateral-current-flow bipolar transistor with high emitter perimeter/area ratio.

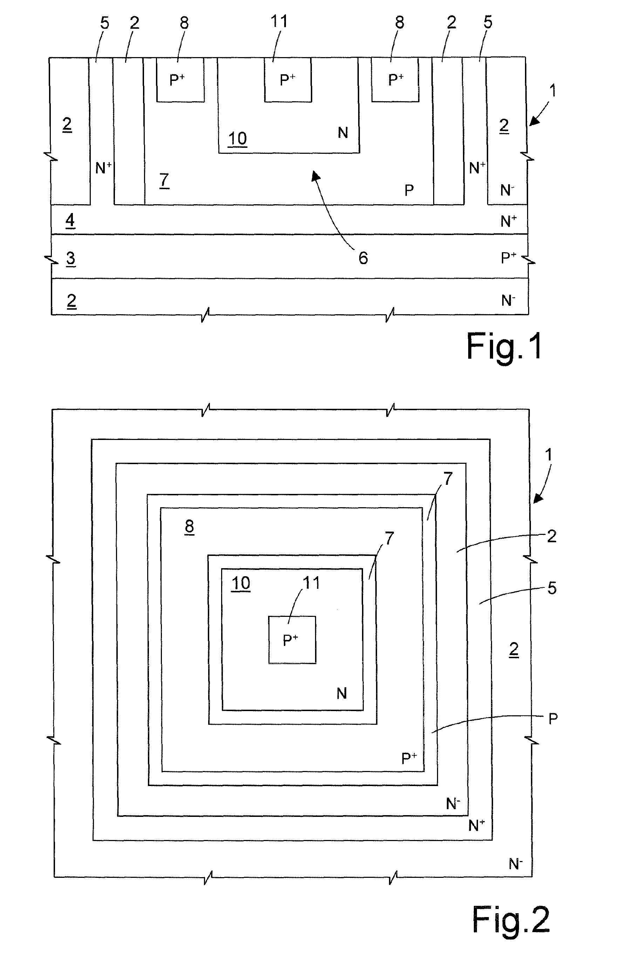

As is known, bipolar transistors may be made with vertical or lateral current flow. In the first case (vertical current flow), it is frequently necessary to use layers dedicated only to form some regions of the transistor. In this way, the transistor may be integrated in a smaller area. In the second case (lateral current flow), it is possible to save on the production of some dedicated layers or regions, but the area required for integration is wider, as may be noted from the comparison between Figures 1 to 4 regarding PNP transistors.

In detail, Figures 1 and 2 illustrate a vertical-current-flow PNP transistor formed in a body 1 and comprising an epitaxial layer 2 of N⁻ type accommodating a first buried layer 3, of P⁺ type; a second buried layer 4, of N⁺ type, on top of the first buried layer 3; an insulation region 5, of N⁺ type and annular shape, extending from the surface of the body 1 as far as the second buried layer 4 and surrounding an insulated region 6; a collector well 7, of P type, inside the insulated region 6; a collector contact region 8, of P⁺ type and an annular shape, extending inside the collector well 6; a base well 10, of N type, extending inside the collector well 6 and surrounded by the collector-contact region 8; and an emitter region 11, of P⁺ type, inside the base well 10.

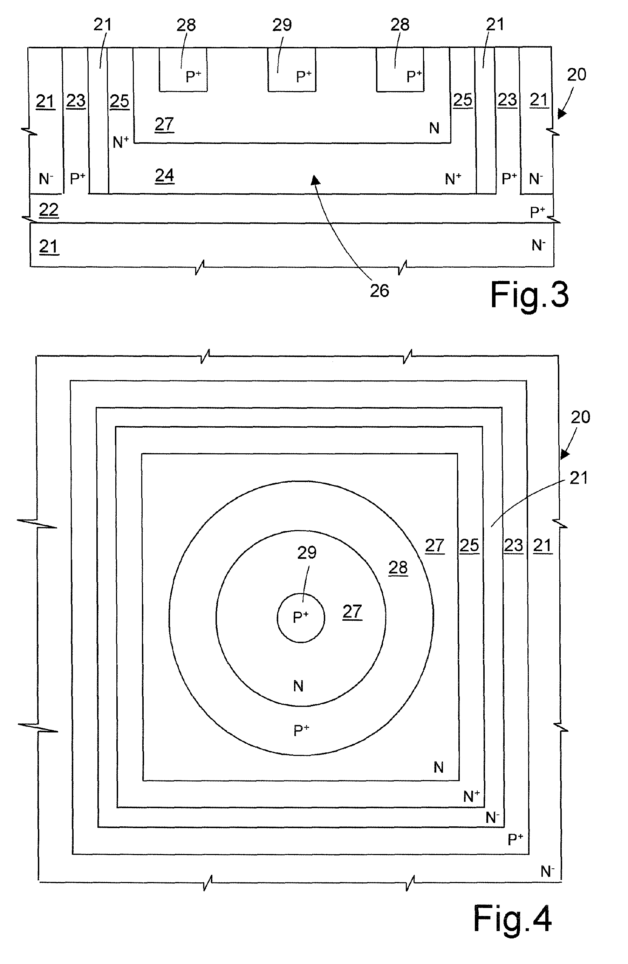

Figures 3 and 4 illustrate a lateral-current-flow PNP transistor formed in a body 20, comprising an epitaxial layer 21, of N⁻ type, accommodating a first buried layer 22, of P⁺ type; an insulation region 23, of P⁺ type and annular shape, extending from the surface of the body 20 as far as the first buried layer 22 and surrounding an insulated region 26; a second buried layer 24, of N⁺ type, on top of the first buried layer 22 inside the insulated region 26; a deep base region 25, of N⁺ type and annular shape, extending inside the insulated region 26 as far as the second buried layer 24; a base well 27, of N type, surrounded by the deep base region 25 and, underneath, by the second buried layer 24; a collector region 28, of P⁺ type and annular shape, inside the base well 27; and an emitter region 29, of P⁺ type, surrounded by the collector region 28.

As may be noted from Figures 3 and 4, the electrical performance of the lateral-current-flow transistor is regulated mainly by the geometry of the collector region 28 and of the emitter region 29, which are annular and concentric. In particular, the current gain h_{FE} depends upon the distance between the collector region 28 and the emitter region 29 and upon the charge of the base well 27, whereas the current that can be carried depends upon the facing area between the collector region 28 and the emitter region 29, which is proportional to the perimeter or circumference thereof.

As may be noted from the comparison between Figures 2 and 4, the dimensions of a lateral-current-flow PNP transistor are significantly larger than those of a vertical-current-flow PNP transistor and increase considerably with the current.

The aim of the present invention is to provide a lateral-current-flow bipolar transistor able to carry a greater amount of current than known solutions, without increasing significantly the surface area.

According to the present invention, there is provided a lateral-current-flow bipolar transistor, as defined in claim 1.

In practice, the transistor comprises a base well with a first conductivity type, which accommodates conductive regions with a second conductivity type forming emitter and collector regions. One of the emitter and collector regions comprises an internal conductive region and an external conductive region, wherein the external conductive region has an annular shape and the internal conductive region extends internally and at a distance from the external conductive region, and another of the emitter and collector regions comprises an intermediate conductive region, of an annular shape, which extends between and at a distance from the internal and external conductive regions.

For a better understanding of the invention, an embodiment thereof is now described, purely by way of non-limiting example and with reference to the attached drawings, wherein:
- Figure 1 illustrates a cross-section of a known vertical-current-flow PNP transistor;
- Figure 2 illustrates a top view of the transistor of Figure 1;
- Figure 3 illustrates a cross-section of a known lateral-current-flow PNP transistor;
- Figure 4 illustrates a top view of the transistor of Figure 3;
- Figure 5 illustrates a cross-section of a lateral-current-flow PNP transistor, according to one embodiment of the invention; and
- Figure 6 illustrates a top view of the transistor of Figure 5.

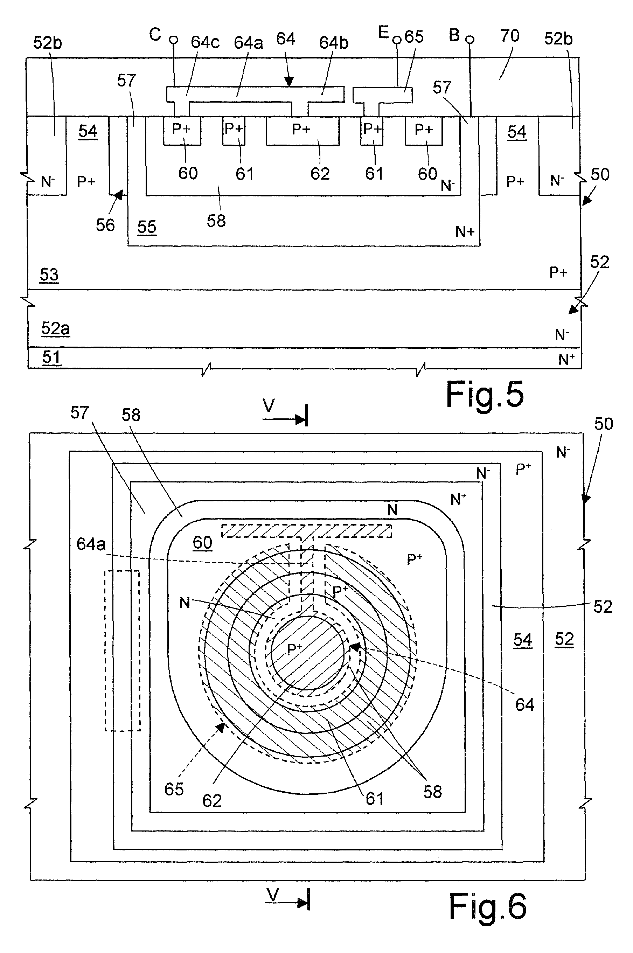

Figures 5 and 6 illustrate an embodiment of a lateral-current-flow PNP transistor formed in a body 50 comprising a substrate 51, of N⁺ type, and an epitaxial layer 52, of N⁻ type, formed by a bottom portion 52a and by a top portion 52b. A first buried layer 53, of P⁺ type, extends between the bottom portion 52a and the top portion 52b of the epitaxial layer 52; an insulation region 54, of P⁺ type and annular shape, extends from the surface of the body 50 as far as the first buried layer 53, and delimits, together with the latter, an insulated region 56. A second buried layer 55, of N⁺ type, extends inside the insulated region 56 on top of and in contact with the first buried layer 53; a deep base region 57, of N⁺ type and annular shape, extends inside the insulated region 56 as far as the second buried layer 55, and delimits, in the top portion 52b of the epitaxial layer 52, a base well 58. The base well 58 accommodates an external collector region 60, of P⁺ type and annular shape; an emitter region 61, of P⁺ type and annular shape, surrounded by the external collector region 60; and an internal collector region 62, of P⁺ type and circular shape, surrounded by the emitter region 61.

An insulating layer 70 extends on top of the body 50 and accommodates metal contacts and connection lines, enabling electrical connection of the various regions; in particular, the collector regions 60, 62 are electrically connected to a same collector electrode C by a collector-connection region 64 comprising a portion 64b overlying the internal collector region 62; a portion 64c overlying the external collector region 60; and a connection portion 64a extending on top of the emitter region 61. In addition, the emitter region 61 is connected to an emitter electrode E through a C-shaped emitter-connection region 65 (represented hatched in Figure 6) to enable, in the open area, the passage of the connection portion 64a and the connection between the collector regions 60, 62. The collector-connection region 64 and the emitter-connection region 65 are formed in a same metal layer.

By virtue of the annular shape of the emitter region 61 and its intermediate arrangement between the two collector regions 60, 62, which enables the emitter region 61 to face the collector regions both on the both its internal and on the external circumferences, the emitter-collector facing area is considerably increased, without this leading, on the other hand, to any significant increase in the total area. Thereby, the current injected from the internal circumference of the emitter region 61 is collected by the internal collector region 62 and sent, together with the current collected by the external collector region 60, to the collector electrode C through the contact region 64.

The process of fabrication of the PNP transistor of Figures 5 and 6 is described hereinafter.

On the substrate 51 with a high dopant concentration of N type a bottom portion 52a of the epitaxial layer 52 is grown. The concentration and thickness of the bottom portion 52a are chosen appropriately according to the voltage levels required for operation of the finished device.

The first and second buried layers 53, 55 are then formed on the bottom portion 52a of the epitaxial layer, by ion implantation and a subsequent diffusion, the second buried layer 55 being made with a smaller area and set on top of the first buried layer 53.

Next, on top of the bottom portion 52a, a top portion 52b of the epitaxial layer 52 is grown; then, the insulation region 54 is formed in the top portion 52b of the epitaxial layer 52, by ion implantation and subsequent diffusion step, the insulation region 54 reaching the first buried layer 53 and delimiting, together with the latter, the insulated region 56. Next, the deep base region 57 is formed once again by ion implantation and subsequent diffusion step; the deep base region 57 reaches the second buried layer 55 on its edge and delimits, in the top portion 52b of the epitaxial layer 52, the base well 58.

Next, the collector regions 60, 62 and the emitter region 61, of P⁺ type are formed by ion implantation, in a concentric way with respect to one another. The electrical contacts, the electrical-connection regions, and the electrodes E, B, C associated to the different regions of the transistor, are formed on the front surface of the wafer 50, using photolithography and deposition techniques.

The bipolar transistor described above presents the following advantages.

The formation of an annular-shaped emitter region 61 enables division of the collector region into internal and external portions (collector regions 62, 60), which are electrically connected in parallel by a metal connection region, and hence enables maximization of the facing area between emitter and collector, which now comprises both the external and the internal lateral surfaces of the emitter region. Consequently, the emitter current is higher than in a known PNP transistor thanks to the ratio between the total length of the respective circumferences (a total length which, for the emitter region 61, comprises both the internal and the external circumferences, as indicated in the figure).

For a current of the same amplitude, the area of silicon occupied by the transistor according to the invention is much smaller in known PNP transistors.

The described structure enables two PNP transistors to be obtained which have the same emitter and independent collectors, the currents whereof are in proportion to the internal circumference/external circumference of the emitter region. In this way, the so-called "matched transistors" solution is obtained, without, on the other hand, any need to design two transistors close to one another, which calls for more space.

The structure described herein enables, as indicated, provision of two transistors with different values of h_{FE}. In fact, by setting each of the collector regions at an appropriate distance from the emitter region, thereby effectively adjusting the facing area between the emitter and each collector region, it is possible to obtain any combination of h_{FE} gains, with a considerable advantage in space as compared to a traditional solution that uses two distinct transistors having different gains.

Finally, it is evident that modifications and variations may be made to the bipolar transistor described herein, without thereby departing from the scope of the present invention.

For example, the same solution may be used for NPN transistors by reversing the conductivity type of the various regions, should the process envisage corresponding layers and steps, or by adding a single layer.

In addition, the exact shape of the different regions (emitter, collector, insulation) may vary. Furthermore, if necessary, an additional emitter ring and an additional collector ring may be provided outside the regions 60-62.

## Claims

1. A transistor of integrated lateral-current-flow type, comprising a base well (58) of a first conductivity type accommodating conductive regions (60-61) having a second conductivity type and forming emitter and collector regions, **characterized in that** one of said emitter and collector regions comprises an internal conductive region (62) and an external conductive region (60), said external conductive region (60) having an annular shape and said internal conductive region (62) extending internally and at a distance from said external conductive region, and **in that** another of said emitter and collector regions comprises an intermediate conductive region (61), of an annular shape, extending between and at a distance from said internal and external conductive regions.

2. The transistor according to claim 1, wherein said internal, intermediate and external conductive regions (60-62) are concentric to each other.

3. The transistor according to claim 1 or 2, wherein said internal conductive region (62) is of solid shape.

4. The transistor according to any one of the preceding claims, wherein said internal conductive region (62) has a substantially circular shape, said intermediate conductive region (61) has a substantially annular shape, and said external conductive region (60) has an internal perimeter with a substantially circumferential shape.

5. The transistor according to any one of the preceding claims, wherein said internal conductive region (62) and said external conductive region (60) are electrically connected by a metal region (64) extending on top of said base well (58).

6. The transistor according to claim 5, comprising: an internal metal region (64b), overlying and in electrical contact with said internal conductive region (62); an intermediate metal region (65), of open shape, overlying and in electrical contact with said intermediate conductive region (61), said intermediate metal region having two facing ends set at a distance apart from one another; an external metal region (64c), overlying and in electrical contact with said external conductive region (62); and a metal connection region (64a), connecting said internal metal region (64b) to said external metal region (64c) and extending between said ends of said intermediate metal region (65).

7. The transistor according to claim 6, wherein said internal, intermediate, external and connection metal regions (64b, 65, 64a, 64c) extend on a same level.

8. The transistor according to any one of the preceding claims, wherein said internal and external conductive regions (62, 60) are collector regions and said intermediate region (61) is an emitter region.

9. The transistor according to any one of the preceding claims, forming a transistor of PNP type.
